# EUROPEAN PATENT APPLICATION

(11) **EP 4 679 968 A1**
(43) Date of publication of application: **14.01.2026**
(21) Application number: 24187398.3
(22) Date of filing: 09.07.2024
(51) Int. Cl.: H10D 64/00, H10D 62/10, H10D 30/66

(54) **METAL OXIDE SEMICONDUCTOR FIELD EFFECT TRANSISTOR, MOSFET, HAVING A REDUCED ON-RESISTANCE AS WELL AS A REDUCED OUTPUT CAPACITANCE, AS WELL AS A CORRESPONDING METHOD AND A SEMICONDUCTOR PACKAGE**

(71) Applicant: Nexperia B.V., 6534 AB Nijmegen (NL)
(72) Inventor: Peake, Steven, Manchester, SK7 5BJ (GB); Pandey, Deepak Chandra, Manchester (GB)
(74) Representative: Pjanovic, Ilija

(57) **Abstract**

A Metal Oxide Semiconductor, MOS, Field Effect Transistor, FET, MOSFET, comprising a semiconductor body having a first major surface and heterogeneous trenches extending in the semiconductor body from the first major surface into the semiconductor body, said heterogeneous trenches comprising: a gate trench of a first type (101) and a gate trench of a second type (1011), said second type being different to said first type, wherein the gate trenches of the first type has a first width and gate trench of the second type has a second width, wherein said first width differs from said second width.

## Description

### Technical Field

The present disclosure relates to Metal Oxide Semiconductor Field Effect Transistors, MOSFETs and, more specifically, to heterogeneous structures in said MOSFETs.

### Background

In the field of power electronics, efficient and reliable semiconductor devices are of importance for a wide range of applications, from consumer electronics to industrial machinery. Among these devices, Metal-Oxide-Semiconductor Field-Effect Transistors, MOSFETs, play an important role. MOSFETs are widely used as electronic switches and amplifiers in various circuits due to their high efficiency, fast switching speeds, and ability to handle elevated power levels. Over the years, advancements in MOSFET technology have been essential in improving the performance and efficiency of electronic devices.

An innovation in this area that is of significance is the development of Shield Gate Trench, SGT, MOSFETs with source-biased Shield Field Plates, FP. This advanced transistor design has been developed by semiconductor manufacturers due to its increased ability to achieve decreased specific on-resistance as well as increased breakdown voltage, typically ranging from 25V to 200V by using the RESURF principle, which increases the electric field distribution within the device.

Traditional MOSFETs may be designed with a planar structure where the current flows horizontally through the silicon substrate. However, to enhance current density and reduce on-resistance, modern designs such as trench MOSFETs have been developed. In trench MOSFETs, the gate electrode is placed in a vertical trench etched into the silicon substrate, allowing for a vertical current flow. This vertical design may improve the utilization of the silicon area and may support higher current densities, resulting in better performance and efficiency.

The SGT MOSFET takes this concept further by incorporating a shield gate between the main gate and the drain. This shield gate serves to reduce the Miller capacitance-the capacitance between the gate and the drain-which in turn improves switching speeds and reduces switching losses. Such a configuration is particularly beneficial in high frequency switching applications where efficiency is critical.

A feature that may be of importance in the SGT MOSFET is the source-biased Shield Field Plate, FP. This field plate is an extension of the gate structure that overlaps the drift region, which is the area between the gate and the drain. By connecting the field plate to the source terminal, the electric field within the drift region is more evenly distributed, reducing peak electric fields at the gate-drain junction. This even distribution is achieved through the reduced surface field, RESURF, principle, which enhances the device's breakdown voltage and lowers the On-State Resistance

The advantages of SGT MOSFETs with source-biased Shield FP include reduced conduction losses, improved thermal performance, and lower gate charge, all of which contribute to higher efficiency in power electronic applications. These devices are particularly well-suited for use in DC-DC converters, power supplies, motor drives, and automotive electronics, where efficiency and reliability are of importance.

However, the SGT FP concept does not come without drawbacks, because to achieve the lowest possible Specific On-State Resistance, the concept requires a narrow cell pitch, typically less than 1 µm. However, this cell pitch is limited by the trench width where a minimum liner oxide thickness is required to meet the breakdown voltage. A larger breakdown voltage rating will require an increased minimum oxide thickness.

Furthermore, the improvement of the specific on-resistance may be achieved at the expense of a higher output capacitance, and as the cell pitch reduces, the impact may be magnified and the MOSFET may suffer from increased switching losses.

### Summary

It would be advantageous to achieve a MOSFET having heterogeneous trenches, which are able to provide a narrower cell pitch and an increased SGT cell pitch, thereby reducing the output capacitance.

In the first aspect of the present disclosure, there is provided a Metal Oxide Semiconductor, MOS, Field Effect Transistor, FET, MOSFET, comprising a semiconductor body having a first major surface and heterogeneous trenches extending in the semiconductor body from the first major surface into the semiconductor body, said heterogeneous trenches comprising:
- a gate trench of a first type; and
- a gate trench of a second type, said second type being different to said first type; wherein
- the gate trench of the first type has a first width and gate trench of the second type has a second width, wherein said first width differs from said second width.

The inventors have found that it may be beneficial to provide a MOSFET comprising a semiconductor body, wherein heterogeneous trenches are provided. These heterogeneous trenches comprise a different width. The above may solve the problems in the prior art. By incorporating heterogeneous trenches, the cell pitch of neighbouring trenches is reduced, thereby reducing the On-State Resistance of the MOSFET.

Furthermore, it also increases the cell pitch from homogeneous trenches, which is the distance between a gate trench of the first type and the gate trench of the same first type. To be clear: A gate trench of a different type, i.e. the second type, is then in between those two gate trenches of the first type.

In an example of the present disclosure, wherein:
- the gate trench of the first type comprising a first gate electrode and a shield electrode, separated from the first gate electrode by an insulation material, and wherein the first gate electrode is positioned between the first major surface and the shield electrode;
- the gate trench of the second type comprising a second gate electrode, and wherein underneath said second gate electrode said gate trench of said second type comprises insulation material only.

In this example, the heterogeneous trenches differ in that the gate trench of the first type comprises a shield electrode, which has the effect of reducing the Specific On-State Resistance, Rds(on), of the MOSFET. The gate trench of the first type may also be called the SGT trench.

The gate trench of the second type, SOTR trench, is introduced to decrease the cell pitch between the gate trench of the first and second type, thereby reducing the Specific On-State Resistance of the MOSFET.

The accompanying effect is that the SGT cell pitch, the distance between two SGT trenches, is increased. This has the effect of reducing the output capacitance, without impacting the specific on-resistance. To reduce the output capacitance, the shield electrode is omitted in the SOTR trench, reducing the overall output capacitance of the MOSFET by a factor of 2. This is because for the SOTR trench, the capacitance between the drain and the source is almost zero, meaning that the output capacitance merely depends on the gate-drain capacitance. For the SGT trench, the capacitance is the sum of the drain-source and the gate-drain capacitance. However, because the drain-source capacitance is the main contributor to the capacitance, the capacitance in the SOTR trench may be low, such that the SGT trench is the main contributor to the overall capacitance of the MOSFET. Therefore, the overall output capacitance of the MOSFET is reduced by a factor of 2.

In a further example of the present disclosure, the gate trench of the first type and the gate trench of the second type extend substantially a same depth in the semiconductor body.

This may improve the field line distribution in the MOSFET, which may improve the overall performance of the MOSFET.

In a further example of the present disclosure, the semiconductor body comprises alternating gate trenches of said first type and said second type.

In the example, the heterogeneous trenches are positioned in an alternating pattern. This may be done to achieve the benefits explained with reference to the shield electrode, while introducing a larger distance between the SGT trenches, which adds the benefits as mentioned before. Therefore, it may be beneficial to place the gate trenches in an alternating pattern.

In a further example of the present disclosure, wherein the gate trench of the second type extends less into said semiconductor body compared to said gate trench of the first type.

Typically, etching a wider trench will result in a slightly deeper trench compared to etching a narrower trench.

In the example, the SOTR trench extends less into the semiconductor body compared to the gate trench. However, they still both extend substantially a same depth in the semiconductor body, as disclosed above. This adds the benefit of lowering manufacturing constraints. The example namely arises during manufacturing, because of the narrower nature of the SOTR trench compared to the SGT trench, which comprises the shield trench and therefore has a larger width.

In a further example of the present disclosure, the width of the trench gate of the second type is equal or less than the width of the trench gate of the first type minus a width of said shield electrode.

A maximum width of the SOTR trench may be 2 times the width of the liner oxide in the SGT trench. Any wider and the trench may not be entirely filled with dielectric. A minimum width of the SGT trench may be determined by trench etch manufacturing capability and may be less than 2 times SGT liner thickness. A typical width for a 40V rated devices may be 0.20µm, which is about 1.5 times the SGT liner thickness. As mentioned above the width of the trench gate of the second type is less than the width of the first trench but has a less or equal width than the width of the first trench minus the width of the shield electrode. Decreasing the width of the SOTR trench may decrease the cell pitch further, therefore it may be beneficial to reduce the width of the SOTR trench.

In a further example of the present disclosure, a cell pitch of the MOSFET is in between 0.5µm and 1.2µm and preferably in between 0.55µm and 0.70µm.

The inventors have found that it might be beneficial to provide a cell pitch of in between 0.5µm and 1.2µm and preferably in between 0.55µm and 0.70µm and even more preferably in between 0.64µm and 0.66µm, in order to achieve a desired breakdown voltage, of substantially 40 volts, while achieving a low drain-source current. Herein the mesa width may be at least substantially 300 nm. The cell pitch is dependent upon the breakdown voltage rating, where the cell pitch increases with increasing breakdown voltage ratings. The cell pitch, different from the SGT width, may be defined as half of the SGT trench width plus the mesa width plus half of the SOTR trench.

In a further example of the present disclosure, wherein a width of said insulating material between a sidewall of said trench of said first type and said shield electrode is in between 80nm and 200nm and preferably between 130nm and 150nm.

In the example, a liner thickness is described, wherein the liner thickness is the thickness between a sidewall of the trench and the shield electrode, herein the liner thickness contributes to the cell pitch. Therefore, to achieve a cell pitch of most preferably in between 0.52µm and 0.54µm, a liner thickness preferably between 130nm and 150nm may be provided. Herein the mesa width may be 200 nm. This may achieve the desired breakdown voltage and/or low specific on-resistance.

In a further example of the present disclosure, the two heterogeneous gate trenches comprise a trench material and wherein the trench material comprises a dielectric material.

In the example, the gate trenches comprise a dielectric material, which may reduce parasitic capacitance in the trenches as it may act as an electrical isolator.

In a further example of the present disclosure, wherein the shield electrode comprises polysilicon.

In the example, the shield electrode may comprise polysilicon in order to provide a gate functionality, as it comprises a low resistivity and a good thermal stability.

In a further example of the present disclosure, wherein said MOSFET further comprises:
- a source region of a first conductivity type;
- a channel-accommodating region, of a second conductivity type opposite to the first conductivity type, adjacent to sidewalls of the two heterogeneous gate trenches between the source region and an epitaxial layer,
- the epitaxial layer of a first conductivity type, and provided between the channel-accommodating region and a substrate;
- the substrate.

In the example, a epitaxial column, in between the heterogenous trenches, is provide, which comprises a source region, a channel accommodating region and an epitaxial layer, which is positioned on a substrate. The epitaxial column provides the source-drain channel of the MOSFET, which is of importance for the functionality of the MOSFET.

In a further example of the present disclosure, the epitaxial layer has a doping concentration of 10¹⁷ - 1.5 ·10¹⁷cm⁻³.

In the example, the doping concentration may be graded, or it may be substantially uniform in the epitaxial layer.

In a further example of the present disclosure, the semiconductor body comprises any of silicon, silicon carbide and Gallium Nitride.

In a further example of the present disclosure, SOTR width is in between 0.1µm and 3µm and the SGT width is in between 0.4 µm and 0.6 µm. And the gate trench width is roughly equal to 0.5 times the cell pitch. As the drain-source voltage rating of the MOSFET increase, the trench width may scale up in size accordingly.

In a second aspect of the present disclosure, there is provided a method of manufacturing the MOSFET according to the present disclosure, comprising:
- providing said semiconductor body;
- providing said gate trench of said first type with a first width, and
- providing said gate trench of said second type width a second width, wherein said first width differs from said second width.

In the example, the providing of the trench gates of the first type and the second type may happen at least substantially simultaneous.

It a further example of the present disclosure, there is provided a step of providing the shield electrode in the gate trench of the second type.

In a third aspect of the present disclosure, there is provided a semiconductor package, comprising the MOSFET according to the present disclosure, where the semiconductor package comprises an encapsulant.

### Brief description of the figures

Fig. 1 depicts the prior art Reduced Surface Field, RESURF, concept.
Fig. 2 depicts a top view of a heterogeneous trench configuration as disclosed in the present disclosure.
Fig. 3 depicts the MOSFET in accordance with the present disclosure.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

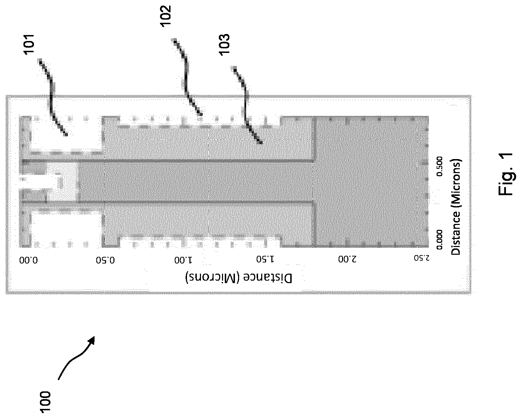

In figure 1, the SGT source biased Shield Field Plate concept 100 according to the prior art is depicted. Herein SGT trenches are provided comprising shield electrodes 102 gates 101 and a liners 103.

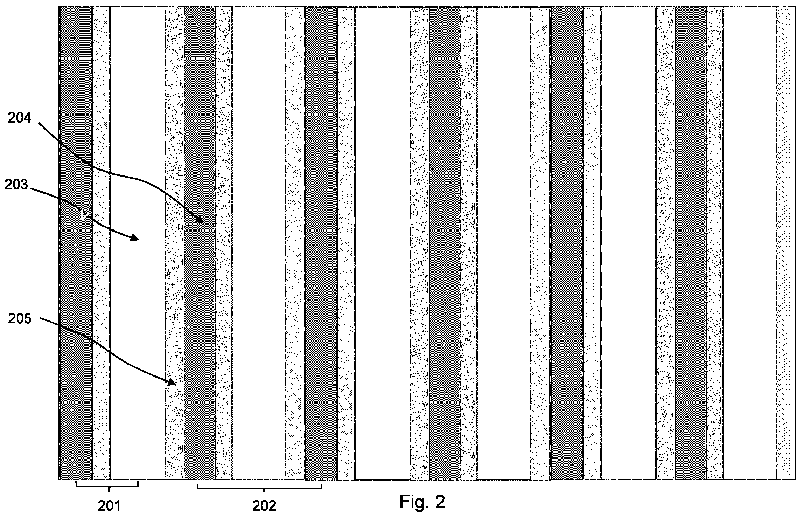

In figure 2, the heterogeneous trench configuration as disclosed in the present disclosure is depicted. Herein, gate trenches of the first type 204, which are SGT trenches, and gate trenches of the second type 203, which are SOTR trenches, are depicted in an alternating configuration. The gate trench centres of the first and second types are separated by a cell pitch 201 and the gate trench centres of the gate trench of a same type are separated by an SGT cell pitch 202, wherein the SGT cell pitch may alternatively be considered as the trench widths of the gate trench of the first and second type plus the epitaxial columns 205, which may be the mesa width, between the trenches of the first and second types.

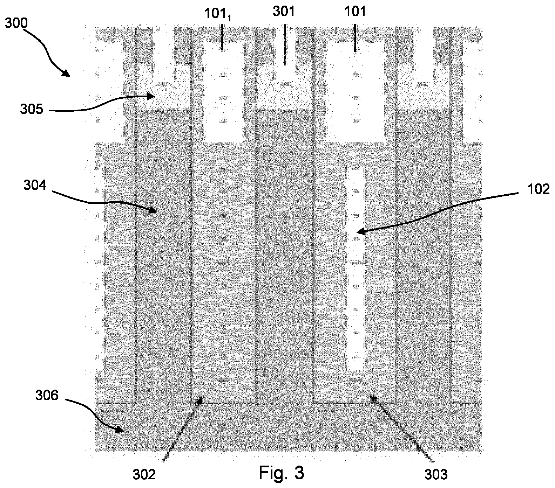

In figure 3, the MOSFET 300 in accordance with the present disclosure is depicted. Herein, the gate trench of the first type 303 and the gate trench of the second type 302 are separated by an epitaxial column 301 305 304. The epitaxial column comprising a source region 301, a channel accommodating region 305 and an epitaxial layer 304. The epitaxial column is positioned vertically on a substrate 306 The gate trench of the first type 303 further comprises a gate 101 and the shield electrode 102. The gate trench of the second type 302 further comprises a gate 101₁.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

## Claims

1. A Metal Oxide Semiconductor, MOS, Field Effect Transistor, FET, MOSFET, comprising a semiconductor body having a first major surface and heterogeneous trenches extending in the semiconductor body from the first major surface into the semiconductor body, said heterogeneous trenches comprising:
- a gate trench of a first type; and
- a gate trench of a second type, said second type being different to said first type; wherein
- the gate trench of the first type has a first width and gate trench of the second type has a second width, wherein said first width differs from said second width.

2. The MOSFET according to claim 1, wherein:
- the gate trench of the first type comprising a first gate electrode and a shield electrode, separated from the first gate electrode by an insulation material, and wherein the first gate electrode is positioned between the first major surface and the shield electrode;
- the gate trench of the second type comprising a second gate electrode, and wherein underneath said second gate electrode said gate trench of said second type comprises insulation material only.

3. The MOSFET in accordance with any of the previous claims, wherein the gate trench of the first type and the gate trench of the second type extend substantially a same depth in the semiconductor body.

4. The MOSFET according to any of the previous claims, wherein the semiconductor body comprises alternating gate trenches of said first type and said second type.

5. The MOSFET according to any of the previous claims, wherein the gate trench of the second type extends less into said semiconductor body compared to said gate trench of the first type.

6. The MOSFET according to any of the previous claims and at least to claim 2, wherein the width of the trench gate of the second type is equal or less than the width of the trench gate of the first type minus a width of said shield electrode.

7. The MOSFET according to any of the previous claims, wherein a cell pitch of the MOSFET is in between 0.5µm and 1.2 µm and preferably in between 0.55µm and 0.70µm and even more preferably in between 0.64µm and 0.66µm.

8. The MOSFET according to any of the previous claims and at least claim 2, wherein a width of said insulating material between a sidewall of said trench of said first type and said shield electrode is in between 80nm and 200nm and preferably between 130nm and 150nm.

9. The MOSFET according to any of the previous claims, wherein the two heterogeneous gate trenches comprise a trench material and wherein the trench material comprises a dielectric material.

10. The MOSFET according to any of the previous claims and claim 2, wherein the shield electrode comprises polysilicon.

11. The MOSFET according to any of the previous claims, wherein said MOSFET further comprises:
- a source region of a first conductivity type;
- a channel-accommodating region, of a second conductivity type opposite to the first conductivity type, adjacent to sidewalls of the two heterogeneous gate trenches between the source region and an epitaxial layer,
- the epitaxial layer of a first conductivity type, and provided between the channel-accommodating region and a substrate;
- the substrate.

12. The MOSFET according to claim 11, wherein the epitaxial layer has a doping concentration of 10¹⁷ - 1.5 ·10¹⁷cm⁻³.

13. The MOSFET according to any of the previous claims, wherein the semiconductor body comprises any of silicon, silicon carbide and Gallium Nitride.

14. A method of manufacturing the MOSFET according to any of the claims 1-13, comprising the steps of:
- providing said semiconductor body;
- providing said gate trench of said first type with a first width; and
- providing said gate trench of said second type width a second width, wherein said first width differs from said second width.

15. The method of manufacturing the MOSFET according to claim 14, wherein the steps of providing of the gate trenches of the first and the second type are preformed simultaneously.

16. A semiconductor package, comprising the MOSFET according to any of the claims 1 - 13, where the semiconductor package comprises an encapsulant.
